# EUROPEAN PATENT SPECIFICATION

(11) **EP 0 525 983 B1**
(45) Date of publication and mention of the grant of the patent: **17.03.1999**
(21) Application number: 92305955.4
(22) Date of filing: 29.06.1992
(51) Int. Cl.: G01R 31/36

(54) **Device for measuring the state of charge of a battery**
Anordnung zur Messung des Ladezustandes einer Batterie
Dispositif de mesure de l'état de charge d'une batterie

(30) Priority: 03.07.1991 GB 9114400
(43) Date of publication of application: 03.02.1993
(73) Proprietor: Yang, Tai-Her, Si-Hu Town Dzan-Hwa (TW)
(72) Inventor: Yang, Tai-Her, Si-Hu Town Dzan-Hwa (TW)
(74) Representative: Arthur, Bryan Edward

(56) References cited:
- DE-A- 2 738 959
- DE-A- 3 100 503
- DE-A- 3 536 111
- GB-A- 2 130 735
- JP-A- 4 134 278
- US-A- 4 052 717
- US-A- 4 259 639
- ELECTRONIC DESIGN. vol. 27, no. 15, 19 July 1979, HASBROUCK HEIGHTS, NEW JERSEY pages 120 - 122 B.ALBING 'Comparator detects power-supply overvoltages, catches glitches'

## Description

The present invention relates to arrangements for detecting and indicating the state of charge of a rechargeable battery on the basis of the internal resistance of the battery.

DE2738959 discloses a battery test circuit in which a load is connected across the test battery. A capacitor, zener diode and light emitting diode are connected in series with each other, the series connected elements being connected in parallel across the load. A switch is arranged to selectively switch the capacitor in series with the load, and the state of charge of the battery is indicated by whether or not the light emitting diode is illuminated.

DE3536111 discloses a battery test circuit in which a battery is periodically short-circuited through a capacitor, and the voltage change of the capacitor is measured by a comparator to measure the battery's capacity.

Besides measuring the specific gravity of the electrolyte, it is only possible to detect the state of charge of a rechargeable battery by measuring the internal resistance of the battery. Battery state-of-charge measuring which is available on the market involves a quite high error during the first half of the load discharge, and the voltage is found floating recovery under the application of discontinuous loads, and after a load is disconnected so that such a voltage measuring method is provided only for reference. Measurement of the internal resistance of a battery is often carried out using a current meter with a series of low resistance elements for direct connection between positive and negative output ends of the battery. Such measurement not only causes a large spark in operation, but the temperature of the battery and the power cord rises extremely quickly, and very high power consumption takes place from the battery. It is very dangerous for a non-professional person to take this action.

According to the present invention, an arrangement for detecting and indicating the state of charge of a rechargeable battery on the basis of the internal resistance of the battery comprises a discharge circuit arranged to be connected to the battery terminals, the discharge circuit including a capacitor and having means for detecting the discharging current into the capacitor, said discharging current being dependent on the internal resistance of the battery, a resistance forming a current limiting means across which the detecting means is arranged to detect a voltage drop, said detecting means comprising an array of series-connected diodes, the diodes being similarly poled and each defining a forward voltage drop, the junctions of the diodes being connected to respective bypass resistors whereby the number of diodes in the array which conduct in response to the application of a voltage drop across said array depends on the magnitude of said voltage drop across said array, and a display or indicating device being arranged to display or indicate the state of charge of the battery by being responsive to the number of diodes which conduct.

The arrangement will normally detect the battery's surplus power by converting RC transient charge internal resistance of the battery into surplus power by adopting RC charge series of capacitance and resistance comprising solid state or mechanical/electrical type switch devices e.g. thyristor or power crystal switch, and parallel connected to each end of the battery, and measuring the internal resistance of the battery indirectly through detecting the RC charging peak value, and displaying the state of charge on analogue or digital display. In real applications, random measuring may be made at any time or periodic measuring may occur. The limiter elements may include a thyristor or external limiter device with inductance and resistance or load elements with limiting function, for example thermoelectric loads, motor loads or lighting loads.

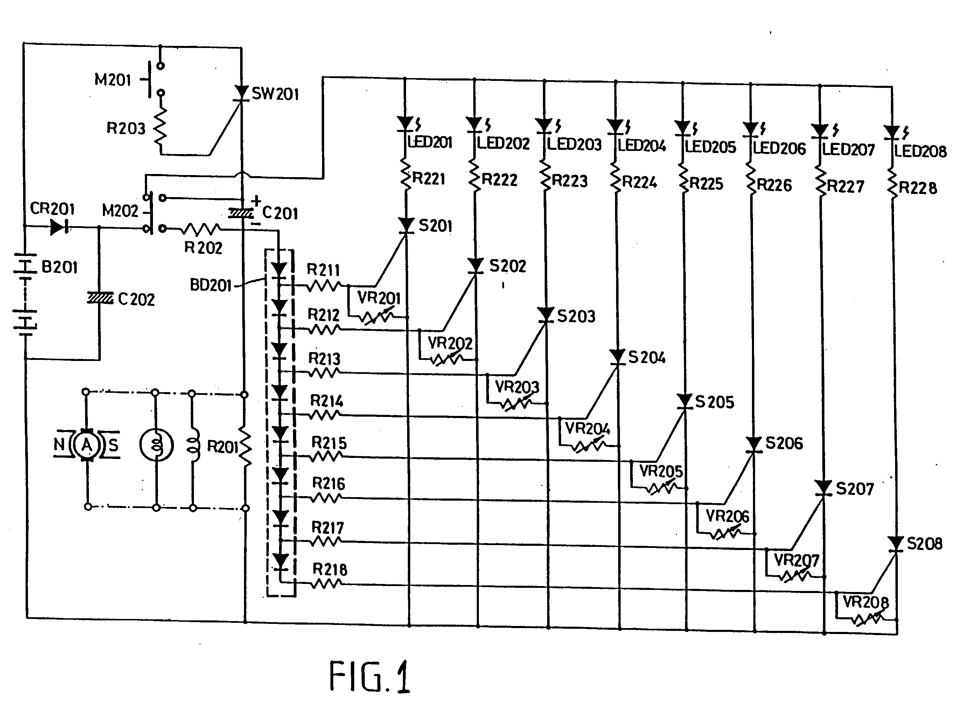

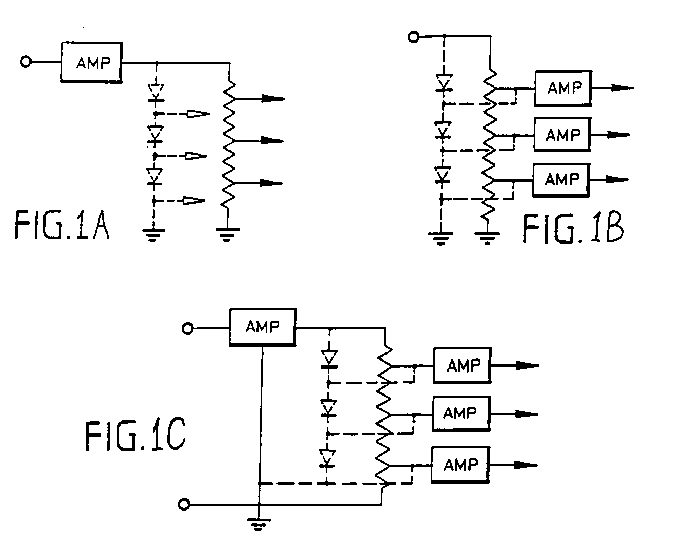

The application is described below in conjunction with Figure 1 which is a circuit diagram showing the arrangement with an analogue display.

To measure the state of charge of a conventional storage battery, unless the specific gravity of the electrolyte is measured, it is only possible to measure the internal resistance of the battery. Voltage measuring methods currently on the market involve quite a high error rate during the discharge of the first half of the charge held within the battery, and the voltage is found floating recovery under discontinuance loading and after interruption of a load so that such a method may be used for reference only. Measuring the internal resistance of the battery is often done using a current meter with a series of low resistance components connected across the positive and negative output ends of the battery in the form of a short circuit. Such measuring not only causes a big spark during operation, but the temperature of the battery and the power cord rises very quickly, and high power consumption occurs. It is dangerous for a non-professional person to carry out such a measurement.

Referring now to Figure 1, a switch device SW201 is a thyristor which receives trigger control from a trigger operating switch M201 so as to switch the test capacitor C201 in series with the battery B201 and the limiter resistance R203 so as to charge the test capacitor C201 through the switch device SW201 and limiter resistance R201.

A differential waveform is formed on each end of the limiter resistance R201, and at the moment the switch device SW201 is turned ON. The capacitance voltage is zero so that the impedance of the circuit is slightly limited by the limiter resistance R201. At that moment, the crest of the differential waveform across the ends of the limiter resistance R201 is inversely proportional to the internal resistance of the battery B201. As we know, the charge held within the battery is inverse to the internal resistance of the battery so that the higher the peak value across the limiter resistance R201, the more charge is held within the battery B201. The differential waveform signal is transmitted to the display circuit directly, or via an amplifier circuit so as to be amplified, or through a truing circuit, and is then transmitted to the display circuit which indicates the level of charge within the battery. The amplifier circuit and display circuit may be constructed to:
1. Directly grade but not to amplify the input signal and transmit it to a switch element.
2. Amplify the input signal jointly and then grade it for transmission to a stick switch element respectively (as in Figure 1A).
3. After grading, then amplifying it and transmitting the signal to a stick switch element (as shown in Figure 1B).
4. After joint amplification, and then grading this signal is transmitted to each individual stick switch element (as shown in Figure 1C).

A manually operated zero return switch moves between an open position in which it is connected in series with a limiter resistance R202, and in parallel across each end of the test capacitor C201 to manually discharge it and give a zero return. In its closed position, it supplies power to the display circuit and is able to cut power off when the display unit returns to zero under normal discharge. The switch may also be controlled by an external signal in which case it may be replaced by a different circuit element.

The positive end of the limiter resistance R201 is connected to one end of a series of diodes BD201 (or zener diodes). The diodes form a voltage level selective circuit with the diodes being positively biased. When the peak value of the limiter resistance is greater than that of series diodes BD201, the signal current causes level type outputs through the diodes to operate the detecting circuit, and each level output of a diode is connected in series with a limiter resistance R201 to R218, and the resistance value is able to operate the display circuit on the basis of the level output, but not to affect the steady differential voltage across the limiter resistance R201. The signal from the resisters R211 - R218 only need to control a thyristor S201 - S208.

Between the limiter resistors R211-R218 and the negative output of the battery B201, it is permitted to connect adjustable or fixed shunt resistances VR201-VR208.

The thyristors S201-S208 are connected in series to light emitting diodes LED201-LED208 and LED limiter resistances R221-R228, its negative end and the negative end of the limiter resistance R201 jointly connected to the negative end of the battery B201, and the positive end is connected to the positive end of the battery B201 through the closed connection of manually operated zero return switch M202, and the gate of each thyristor assembly respectively passes through the limiter resistance R211-R218 and then respectively connected to each series connection of the detecting circuit series diodes BD201 (or zener diodes) in sequence to form a multi-level display circuit. The number of levels can be flexibly selected to enable each thyristor to have a bias value of the diodes BD201 subject to the peak voltage produced by the limiter resistance R201. The trigger of the thyristor assembly enables the light emitting diodes to be illuminated. Each thyristor can include varied level elements with different negative breakdown characteristics and may comprise elements of different conductive voltages such as DIACs or other elements which replace the level type detecting circuit.

A steady voltage circuit is provided for storing power in capacitor C202 (or auxiliary battery) through one way diodes CR201 under normal operation so as to offer a continuous power supply to the display circuit both in normal operation and during measurement.

The detecting capacitor of the measuring circuit may be connected in parallel to discharge through a resistance so as to detect internal resistance transient state of the battery for displaying the state of charge of the battery indirectly when discharge is ended and the detecting circuit is re-started. This is only an example, and it is also possible to carry out periodic measurements by adding a timing operation device.

Thus, the invention manages to allow the state of charge of a battery to be measured easily without professional manual short-circuit measuring. Current from the battery is discharged into a capacitor and the resulting voltage from across a resistor is detected by an array of diodes BD201 which each define a predetermined forward voltage drop and emerge an array of LED's via respective variable resistors. The greater the initial current surge into the capacitor, the lower the internal resistance of the battery and the greater the number of LED's illuminated by the bar graph display (see Figure 1).

## Claims

1. An arrangement for detecting and indicating the state of charge of a rechargeable battery (B201) on the basis of the internal resistance of the battery (B201), the arrangement comprising a discharge circuit arranged to be connected to the battery terminals, the discharge circuit including a capacitor (C201) and having means for detecting the discharging current into the capacitor (C201), said discharging current being dependent on the internal resistance of the battery (B201), a resistance (R201) forming a current limiting means across which the detecting means is arranged to detect a voltage drop, said detecting means comprising an array (BD201) of series-connected diodes, the diodes being similarly poled and each defining a forward voltage drop, the junctions of the diodes being connected to respective bypass resistors (R211-R218) whereby the number of diodes in the array (BD201) which conduct in response to the application of a voltage drop across said array (BD201) depends on the magnitude of said voltage drop across said array (BD201), and a display or indicating device (LED201-LED208) being arranged to display or indicate the state of charge of the battery (B101,B201) by being responsive to the number of diodes which conduct.

2. An arrangement as claimed in claim 1, wherein said display comprises a plurality of light-emitting diodes (LED's) which are connected in parallel and arranged to be switched on individually in response to current passing through respective ones of said bypass resistors (R211-R218).

3. An arrangement as claimed in claim 2, wherein said light-emitting diodes (LED201-208) are arranged to be switched on by respective gate-controlled semiconductor switching devices (S201-S208) whose gate electrodes are connected to respective ones of said bypass resistors (R211-R218).

4. An arrangement as claimed in any of claims 1 to 3, wherein said display is a digital numerical display.

5. An arrangement as claimed in any preceding claim, further comprising a storage capacitor (C202) which is arranged to be maintained charged by the rechargeable battery (B201) at a voltage which is substantially unaffected by discharge of the battery (B201) through said discharge circuit, the detecting means and/or display means being energised by said substantially unaffected voltage.

6. An arrangement as claimed in any preceding claim, comprising first switch means (M201) arranged to discharge the battery (B201) into said capacitor (C201) and second switch means (M202) arranged to discharge the capacitor (C201) after said first switch means (M201) has been switched OFF, said first and second switch means being arranged to be actuated at predetermined intervals by a control means so as to monitor continually the state of charge of the battery (B201).

7. An arrangement as claimed in any preceding claim, comprising an indicating device which is responsive to said discharging current and is arranged to generate a warning signal when the charge stored in the battery falls below a predetermined level.

## Patentansprüche

1. Anordnung zum Ermitteln und Anzeigen des Ladezustands eines Akkumulators (B201) aufgrund dessen Innenwiderstands mit einer an die Akkumulatoranschlüsse legbaren Entladeschaltung mit einem Kondensator (C201) und einer Einrichtung zum Erfassen des in den Kondensator fließenden und vom Innenwiderstand des Akkumulators (B201) abhängigen Entladestroms, einem Widerstand (R201), der einen Strombegrenzer bildet und über den eine Erfassungseinrichtung gelegt ist, mit der ein Spannungsabfall erfaßbar ist, wobei die Erfassungseinrichtung eine Kette (BD201) gleichgepolt in Reihe geschalteter Dioden jeweils mit einem Vorwärts-Spannungsabfall aufweist und die gemeinsamen Anschlüsse jeweils zweier Dioden mit zugehörigen Nebenschlußwiderständen (R211 - R218) verbunden sind, so daß die Anzahl der Dioden der Kette (BD201), die unter einem anliegenden Spannungsabfall über ihr aufleuchten, von der Höhe dieses Spannungsabfalls abhängt, und mit einer Anzeigeeinrichtung (LED201 - LED208), die ansprechend auf die Anzahl der durchgeschalteten Dioden den Ladezustand des Akkumulators (B101, B201) anzeigt.

2. Anordnung nach Anspruch 1, bei der die Anzeige eine Vielzahl von Lumineszenzdioden (LEDs) aufweist, die parallelgeschaltet und ansprechend auf die Ströme, die durch die zugehörigen Nebenschlußwiderstände (R211 - R218) fließen, einzeln durchschalten.

3. Anordnung nach Anspruch 2, bei der die Lumineszenzdioden (LED201 - LED208) von zugehörigen, an Gate-Elektroden angesteuerten Halbleiterschaltelementen (S201 - S208) ein-/ausgeschaltet werden, deren Gate-Elektroden mit zugehörigen Nebenschlußwiderständen (R211 - R218) verbunden sind.

4. Anordnung nach einem der Ansprüche 1 - 3, bei der es sich bei der Anzeige um eine numerische Digitalanzeige handelt.

5. Anordnung nach einem der vorgehenden Ansprüche weiterhin mit einem Speicherkondensator (C202), der mit dem Akkumulator (B201) auf eine Spannung geladen haltbar ist, die von der Entladung des Akkumulators (B201) über den Entladekreis im wesentlichen nicht beeinflußt wird, wobei die Erfassungseinrichtung und/oder die Anzeige mit der im wesentlichen unbeeinflußten Spannung gespeist werden.

6. Anordnung nach einem der vorgehenden Ansprüche mit einem ersten Schalter (M201), mit dem der Akkumulator (B201) in den Kondensator (C201) entladbar ist, und einem zweiten Schalter (M202), mit dem der Kondensator (C201) entladbar ist, nachdem der erste Schalter (M201) AUSgeschaltet worden ist, wobei der erste und der zweite Schalter so angeordnet sind, daß sie in vorbestimmten Zeitabständen von einer Steuerung betätigbar sind, um den Ladezustand des Akkumulators (B201) stetig zu überwachen.

7. Anordnung nach einem der vorgehenden Ansprüche mit einer Anzeigeeinrichtung, die auf den Entladestrom ansprechend ein Warnsignal abgibt, falls die Ladung im Akkumulator unter ein vorbestimmtes Niveau abfällt.

## Revendications

1. Dispositif pour détecter et indiquer l'état de charge d'une batterie rechargeable (B201) sur la base de la résistance interne de la batterie (B201), le dispositif comprenant un circuit de décharge agencé de manière à être connecté aux bornes de la batterie, le circuit de décharge comprenant un condensateur (C201) et comportant des moyens pour détecter le courant de décharge pénétrant dans le condensateur (C201), ledit courant de décharge dépendant de la résistance interne de la batterie (B201), une résistance (R201) formant des moyens de limitation du courant et aux bornes de laquelle les moyens de détection sont disposés pour détecter une chute de tension, lesdits moyens de détection comprenant un réseau (BD201) de diodes branchées en série, les diodes étant polarisées de façon similaire et chacune définissant une chute de tension dans le sens passant, les jonctions des diodes étant connectées par des résistances respectives de dérivation (R211-R218), ce qui a pour effet que le nombre de diodes dans le réseau (BD201), qui sont conductrices en réponse à l'application d'une chute de tension aux bornes dudit réseau (BD201), dépend de l'amplitude de ladite chute de tension aux bornes dudit réseau (BD201), et un dispositif d'affichage ou un dispositif indicateur (LED201-LED208) étant disposé de manière à afficher ou à indiquer l'état de charge de la batterie (B101, B201) en étant apte à répondre au nombre de diodes qui sont conductrices.

2. Dispositif selon la revendication 1, dans lequel ledit dispositif d'affichage comprend une pluralité de diodes photoémissives (LED), qui sont branchées en parallèle et agencées de manière à être allumées individuellement en réponse au passage d'un courant dans des résistances respectives faisant partie desdites résistances de dérivation (R211-R218).

3. Dispositif selon la revendication 2, dans lequel lesdites diodes photoémissives (LED201-208) sont agencées de manière à être allumées par des dispositifs respectifs de commutation à semiconducteurs (S201-S208) commandés par la grille, dont les électrodes de grille sont connectées à des résistances respectives faisant partie desdites résistances de dérivation (R211-R218).

4. Dispositif selon l'une quelconque des revendications 1 à 3, dans lequel ledit dispositif d'affichage est un dispositif d'affichage numérique.

5. Dispositif selon l'une quelconque des revendications précédentes, comprenant en outre un condensateur de stockage (C202) qui est agencé de manière à être maintenu chargé par la batterie rechargeable (B201), à une tension qui est sensiblement non affectée par la décharge de la batterie (B201) dans ledit circuit de décharge, les moyens de détection et/ou les moyens d'affichage étant alimentés par une tension sensiblement non affectée.

6. Dispositif selon l'une quelconque des revendications précédentes, comprenant des premiers moyens de commutation (M201) agencés de manière à décharger la batterie (B201) dans ledit condensateur (C201) et des seconds moyens de commutation (M202) agencés de manière à décharger le condensateur (C201) après que lesdits premiers moyens de commutation (M201) ont été désactivés, lesdits premiers et seconds moyens de commutation étant agencés de manière à être actionnés à des intervalles prédéterminés par des moyens de commande de manière à contrôler continûment l'état de charge de la batterie (B201).

7. Agencement selon l'une quelconque des revendications précédentes, comprenant un dispositif indicateur, qui est apte à répondre audit courant de décharge et est agencé de manière à produire un signal d'avertissement lorsque la charge stockée dans la batterie tombe au-dessous d'un niveau prédéterminé.
